(19) Europäisches Patentamt
European Patent Office
Office européen des brevets

(11) **EP 1 753 131 B1**

(12) **EUROPÄISCHE PATENTSCHRIFT**

(45) Veröffentlichungstag und Bekanntmachung des Hinweises auf die Patenterteilung:
**25.01.2012 Patentblatt 2012/04**

(51) Int Cl.:
*H03G 11/02* (2006.01)    *H04B 1/713* (2011.01)
*H03K 19/177* (2006.01)

(21) Anmeldenummer: **06010275.3**

(22) Anmeldetag: **18.05.2006**

(54) **Vorrichtung und Verfahren zum Begrenzen von Störamplituden**

Device and method for limiting parasitic amplitudes

Dispositif et méthode de limitation des amplitudes parasites

(84) Benannte Vertragsstaaten:
**DE ES FR GB IT PT**

(30) Priorität: **09.08.2005 DE 102005037617**

(43) Veröffentlichungstag der Anmeldung:
**14.02.2007 Patentblatt 2007/07**

(73) Patentinhaber: **Rohde & Schwarz GmbH & Co. KG
81671 München (DE)**

(72) Erfinder:
• **Valten, Thomas
82008 Unterhaching (DE)**
• **Schmidt, Jürgen
85221 Dachau (DE)**

(74) Vertreter: **Körfer, Thomas et al
Mitscherlich & Partner
Patent- und Rechtsanwälte
Postfach 33 06 09
80066 München (DE)**

(56) Entgegenhaltungen:
**EP-A- 0 419 186     US-A- 3 277 384
US-A- 4 256 975**

**Beschreibung**

Die vorliegende Erfindung bezieht sich auf eine Vorrichtung zum Begrenzen von Störamplituden und ein entsprechendes Verfahren.

Aus der EP 0 419 186 B1 ist eine Amplitudenbegrenzer-Schaltung zum Begrenzen des Eingangssignals auf einen vorbestimmten Pegel bekannt. Nachteilig bei der in der EP 0 419 186 B1 beschriebenen Amplitudenbegrenzer-Schaltung ist, dass der Begrenzungspegel ein festgelegter Wert ist. Weist die zu begrenzende Amplitude eines Nutzsignals eine hohe Dynamik auf, was bedeutet, dass im Nutzsignal neben sehr kleinen Signalamplituden auch sehr hohe Signalamplituden auftreten, so werden die Signalbestandteile mit den sehr hohen Amplituden von der Amplitudenbegrenzer-Schaltung abgeschnitten, was in einem der Amplitudenbegrenzer-Schaltung nachgeschalteten Verstärker zu Verzerrungen führen kann. Bei Audiosignalen kann das eine Verminderung der Qualität des wiedergegebenen Signals bewirken.

Wird z. B. bei einem Frequenzsprungverfahren auf eine neue Frequenz umgeschaltet, so treten während der Dauer des Umschaltvorgangs im demodulierten Audiosignal Störimpulse auf. Das Auftreten dieser Störimpulse ist periodisch, wobei die zeitliche Periode der Störimpulse der Frequenz des Frequenzsprungverfahren entspricht.

Aus der Patentschrift US 3,277,384 ist ein Begrenzen mit einem vom Signalverlauf abhängigem Schwellenwert bekannt.

Der Erfindung liegt daher die Aufgabe zugrunde, diese periodisch auftretenden Störimpulse so zu begrenzen, dass das eigentliche Nutzsignal nicht verzerrt wird.

Diese Aufgabe wird erfindungsgemäß durch die in Anspruch 1 beschriebene Vorrichtung und durch das Verfahren gemäß Anspruch 12 gelöst. Vorteilhafte Weiterbildungen der Erfindung sind in den Unteransprüchen angegeben.

Am Ausgang der Vorrichtung zum Begrenzen von Störamplituden in Signalverläufen auf dynamisch ermittelte, relativ zu einem mittleren Signalverlauf einstellbare Schwellenwerte wird entweder beim Erreichen der Begrenzung ein in der Vorrichtung ermittelter Schwellenwert oder der am Eingang anliegende Signalverlauf ausgegeben, wenn die Begrenzung noch nicht erreicht ist. Die Schwellenwerte werden erfindungsgemäß dynamisch aus dem Signalverlauf gebildet, von welchem innerhalb eines definierten Zeitraums Mittelwerte berechnet werden, wobei diese Mittelwerte zur Bildung der Schwellenwerte mit einem Offset versehen werden.

Ein Vorteil der erfindungsgemäßen Vorrichtung liegt darin, dass diese sowohl in einem digitalen Signalprozessor als auch in Hardware implementiert werden kann.

Ein weiterer Vorteil der vorliegenden Vorrichtung besteht in der Möglichkeit, diese mit der gleichen Fequenz des Frequenzsprungverfahrens oder eines anderen externen Ereignisses zu takten, so dass die Störunterdrückung nur dann wirksam wird, wenn ein Störimpuls im Audio-Nutzsignal z. B. bei einem Umschalten der Frequenz zu erwarten ist.

Weiter ist es von Vorteil, dass in der Vorrichtung ein Offset definiert ist, so dass gewährleistet ist, dass der ermittelte Schwellenwert größer als die Amplitude des Signalverlaufs ist.

Von Vorteil ist es, dass die erfindungsgemäße Vorrichtung einen adaptiven und zeitvarianten Schwellenwert bestimmt.

Die Erfindung wird nachfolgend unter Bezugnahme auf die Zeichnung näher beschrieben. In der Zeichnung zeigen:

Fig. 1  eine schematische Darstellung eines ersten Ausführungsbeispiels einer erfindungsgemäßen Vorrichtung zum Begrenzen von Störamplituden in Signalverläufen;

Fig. 2  eine schematische Darstellung eines zweiten Ausführungsbeispiels einer erfindungsgemäßen Vorrichtung zum Begrenzen von Störamplituden in Signalverläufen;

Fig. 3  ein Nutzsignal im Zeitbereich mit einem dynamisch an den Signalverlauf angepassten Verlauf der ermittelten Schwellenwerte;

Fig. 4  einen positiven Signalverlauf in einem ersten Signalpfad nach einem Verzweigungsblock und einen mittleren Signalverlauf nach einem ersten Mittelwertbildungsblock;

Fig. 6  den zeitlichen Verlauf des Nutzsignals aus Fig.2 mit periodisch auftretenden Störamplituden;

Fig. 7  den zeitlichen Verlauf des Nutzsignals aus Fig.2 mit periodisch auftretenden Störamplituden, die von den ermittelten Schwellenwerten begrenzt werden;

Fig. 8  eine schematische Darstellung eines zeitlichen Verlaufs eines Frequenzsprungverfahrens mit fünf vorgesehenen Frequenzen $f_1$, $f_2$, $f_3$, $f_4$, $f_5$ und

Fig. 9    den zeitlichen Verlauf eines Frequenzsprungs von der Frequenz $f_1$ auf die Frequenz $f_4$ mit einer endlichen Umschaltdauer $t_d$, der in Fig. 8 mit Ausschnitt IX gekennzeichnet ist.

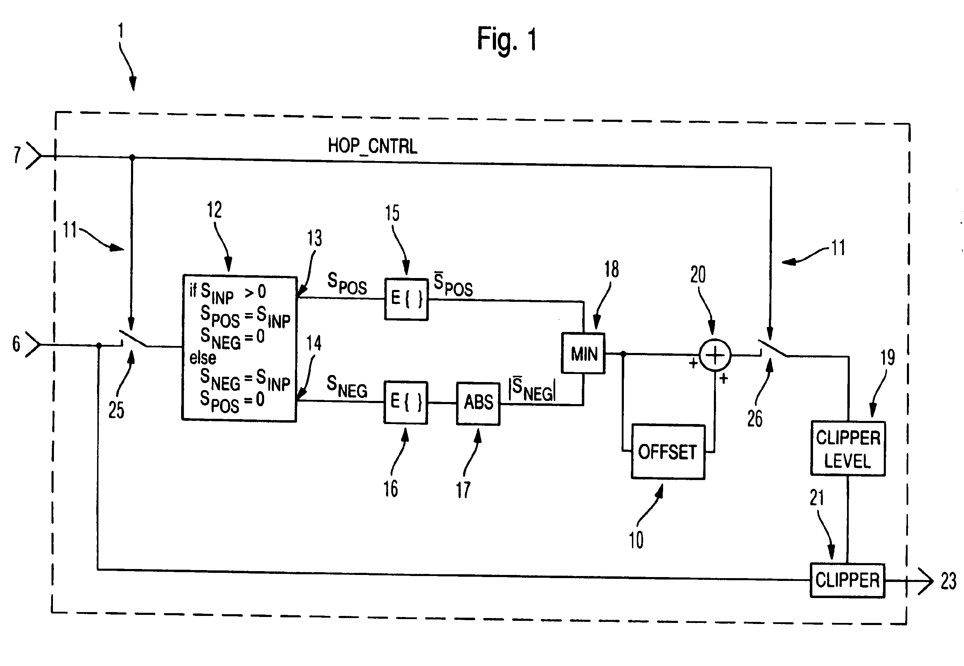

Fig. 1 zeigt eine schematische Darstellung eines ersten Ausführungsbeispiels einer erfindungsgemäßen Vorrichtung 1 zum Begrenzen von Störamplituden 2 in Signalverläufen 3 auf dynamisch ermittelte, relativ zu einem mittleren Signalverlauf 4 einstellbare Schwellenwerte 5. Die erfindungsgemäße Vorrichtung 1 weist einen Eingang 6 und einen Ausgang 23 auf.

Am Ausgang 23 der erfindungsgemäßen Vorrichtung 1 wird entweder der in der Vorrichtung 1 ermittelte Schwellenwert 5 oder der am Eingang 6 anliegende Signalverlauf 3 ausgegeben, wobei die Schwellenwerte 5 aus den Signalverläufen 3 gebildet werden, von welchen innerhalb eines definierten Zeitraums Mittelwerte berechnet werden, wobei diese Mittelwerte zur Bildung der Schwellenwerte 5 mit einem Offset 10, der ein vorher festgelegter, zeitlich konstanter Wert ist, versehen werden.

Die erfindungsgemäße Vorrichtung 1 wird mittels eines Steuersignals 11 (HOP_CNTRL) aktiviert, wobei das über einen zweiten Eingang 7 der Vorrichtung zuführbare Steuersignal 11 (HOP_CNTRL) im Ausführungsbeispiel zeitlich an ein Frequenzsprungverfahren gekoppelt ist, so dass in regelmäßigen zeitlichen Abständen $\Delta t$, die mit den Frequenzsprüngen synchronisiert sind, ein aktualisierter Schwellenwert 5 aus den Mittelwerten 22 berechnet wird.

Unmittelbar nach dem ersten Eingang 6 der erfindungsgemäßen Vorrichtung 1 ist ein erstes Schaltelement 25 angeordnet, das von einem externen oder internen Steuersignal 11 (HOP_CNTRL) betätigt wird. Das erste Schaltelement 25 ist mit einem Verzweigungsblock 12 verbunden, der einen im Basisband vorliegenden Signalverlauf z. B. eines Audiosignals auf zwei Signalpfade 13, 14 aufteilt, wobei der erste Signalpfad 13 die positiven Signalamplituden enthält und der zweite Signalpfad 14 die negativen Signalamplituden enthält.

In beiden Signalpfaden 13, 14 werden die Signalanteile jeweils einem Mittelwertbildungsblock 15, 16 zugeführt, der über einen Zeitraum von z. B. 30 ms einen Mittelwert $\overline{S}_{pos}$ bzw. $\overline{S}_{neg}$ des Signals bildet. Der nach dem zweiten Mittelwertbildungsblock 16 aus den negativen Signalanteilen gebildete Mittelwert $\overline{S}_{neg}$ wird anschließend in einem nach dem zweiten Mittelwertbildungsblock 16 angeordneten Betragsbildungsblock 17 einer Absolutbetrag-Bildung unterworfen. Die positiven Mittelwerte $\overline{S}_{pos}$ und $|\overline{S}_{neg}|$ der positiven und negativen Signalanteile werden in einem Entscheidungsbildungsblock 18, der eingangsseitig mit den beiden Signalpfaden 13, 14 verbunden ist, dahingehend ausgewertet, dass am Ausgang des Entscheidungsbildungsblocks 18 der kleinere Mittelwert $\overline{S}_{pos}$ oder $|\overline{S}_{neg}|$ anliegt. In einem daran angeschlossenen Addierer 20 wird zu diesem Mittelwert 22 der mit einem Offset (Versatz) in einem Offset-Block 10 skalierte Mittelwert addiert, so dass sich ein weiterer Wert ergibt, der vorzugsweise etwas größer ist als der doppelte Mittelwert am Ausgang des Entscheidungsblocks 18.

Nach dem Addierer 20 ist in der erfindungsgemäßen Vorrichtung 1 ein zweites Schaltelement 26 vorgesehen, das bei einer geschlossenen Schaltstellung bewirkt, dass der Wert am Ausgang des Addierers 20 als Schwellenwert (Clipper Level) 5 dynamisch in einem Speicher 19 abgelegt wird. Das vor dem Ausgang 23 der erfindungsgemäßen Vorrichtung 1 angeordnete Begrenzungselement 21 verwendet den im Speicher 19 gespeicherten Schwellenwert 5 für einen Vergleich des am Eingang 6 anliegenden Signalwertes mit dem aktuell vorliegenden Schwellenwert 5, wobei der kleinere der beiden Werte am Ausgang 23 der erfindungsgemäßen Vorrichtung 1 ausgegeben wird.

Der nach dem Addierer 20 vorliegende Schwellenwert 5 ergibt sich aus folgender Formel:

$$\texttt{Schwellenwert = Mittelwert} \bullet \texttt{(1+Offset)}$$

mit Offset > 0, vorzugsweise Offset > 1

Sobald das zweite Schaltelement 26 geschlossen ist, wird in dem Speicher 19 der gerade berechnete neue Schwellenwert 5 abgespeichert.

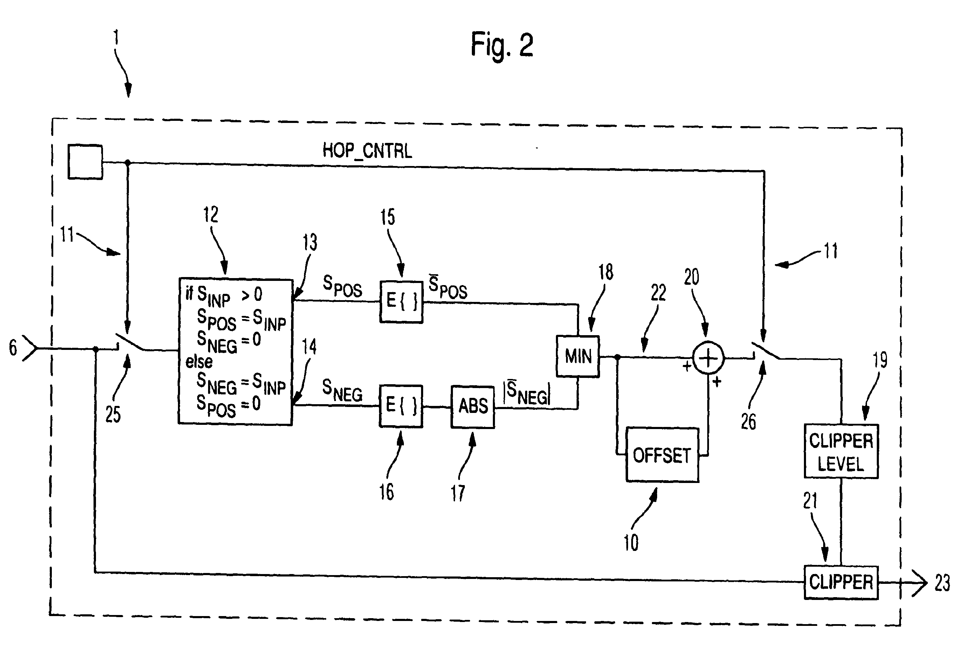

Fig. 2 zeigt eine schematische Darstellung eines zweiten Ausführungsbeispiels einer erfindungsgemäßen, synchron zu einem Frequenzsprungverfahren 24 getakteten Vorrichtung 1 zum Begrenzen von Störamplituden 2 in Signalverläufen 3, wobei das die beiden Schalter betätigende Steuersignal 11 (HOP_CNTRL) im Gegensatz zum ersten Ausführungsbeispiel nicht extern, sondern innerhalb der erfindungsgemäßen Vorrichtung 1 erzeugt wird.

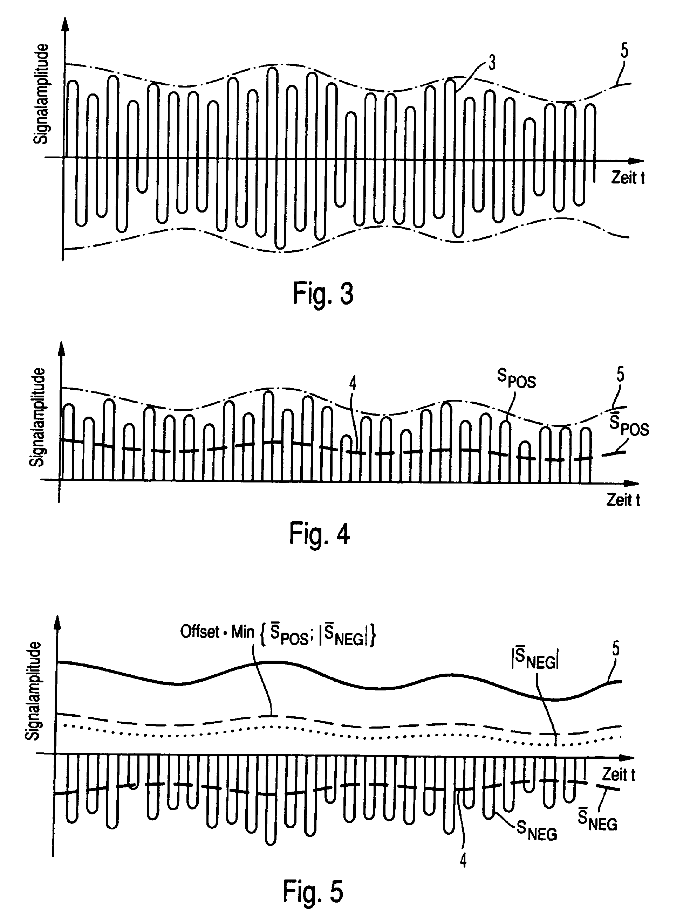

Fig. 3 zeigt einen idealen Signalverlauf 3 im Zeitbereich mit einem dynamisch an den Signalverlauf angepassten Verlauf der Schwellenwerte 5. Der ideale Signalverlauf 3 weist keine Signalamplitude auf, die über die dynamisch an den Signalverlauf angepasste Schwellenwerte 5 hinausgeht. Bei der Darstellung der Figuren 3 bis 7 ist zu berücksichtigen, dass zur Verbesserung der Anschaulichkeit zwar analoge Signalverläufe dargestellt sind, beim bevorzugten Ausführungsbeispiel aber tatsächlich ein digital abgetastetes Signal vorliegt.

Fig. 4 zeigt einen Signalverlauf in dem ersten Signalpfad 13 nach dem Verzweigungsblock 12 und den mittleren Signalverlauf 4 ($\overline{S}_{pos}$) nach einem ersten Mittelwertbildungsblock 15. In dem ersten Signalpfad 13 liegen nur positive Signalverläufe vor.

Fig. 5 zeigt fünf in der erfindungsgemäßen Vorrichtung 1 auftretende Signalverläufe:

- den Verlauf der negativen Signalanteile $S_{neg}$ in dem zweiten Signalpfad 14 nach dem Verzweigungsblock 12 als durchgezogene Kurve;
- den mittleren Signalverlauf 4 ($\overline{S}_{neg}$) des oben beschriebenen Signalverlaufs nach dem zweiten Mittelwertbildungsblock 16 als dicke, gestrichelte Kurve;
- den zeitlichen Verlauf des Absolutbetrags des mittleren Signalverlaufs $|\overline{S}_{neg}|$ nach dem Betragsbildungsblock 17 im zweiten Signalpfad 14 als gepunktete Kurve;
- einen mit einem Offset multiplizierter Signalverlauf Offset $\cdot$ Min $\{\overline{S}_{pos}; |\overline{S}_{neg}|\}$ nach dem Entscheidungsblock 18 als dünne, gestrichelte Kurve;
- den zeitlichen Verlauf des Schwellenwerts (1+Offset) $\cdot$ Min $\{\overline{S}_{pos}; |\overline{S}_{neg}|\}$ nach dem Addierer 20 als durchgezogene fette Kurve.

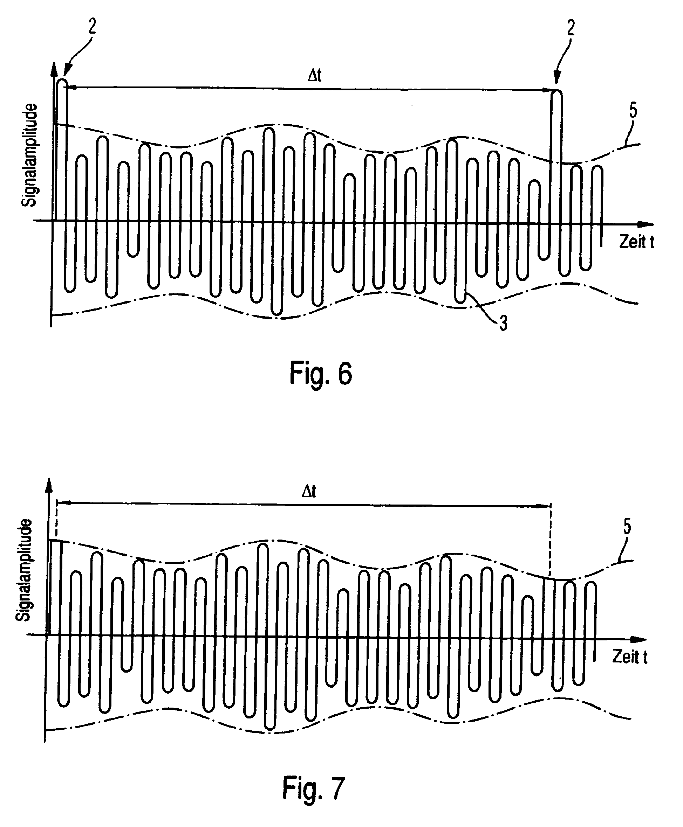

Fig. 6 zeigt den zeitlichen Verlauf des Eingangs-Signals aus Fig.2 mit periodisch auftretenden Störamplituden 2, die deutlich über die Signalamplitude hinaus gehen. Diese Störamplituden 2 kommen z. B. dadurch zustande, dass bei einem Funkübertragungsverfahren ein Frequenzsprungverfahren angewendet wird, wonach jeweils nach einem definierten Zeitintervall $\Delta$t die SendeFrequenz geändert wird. Beim Umschalten auf eine neue Frequenz kommt es jeweils zu Störamplituden 2, die vor einer weiteren Verarbeitung des Signals begrenzt bzw. abgeschnitten werden müssen.

Fig. 7 zeigt den zeitlichen Signalverlauf aus Fig. 2 mit periodisch auftretenden von den dynamisch ermittelten Schwellenwerten begrenzten Störamplituden 2, wobei die Störamplituden 2 sowohl positiv auch negativ sein können.

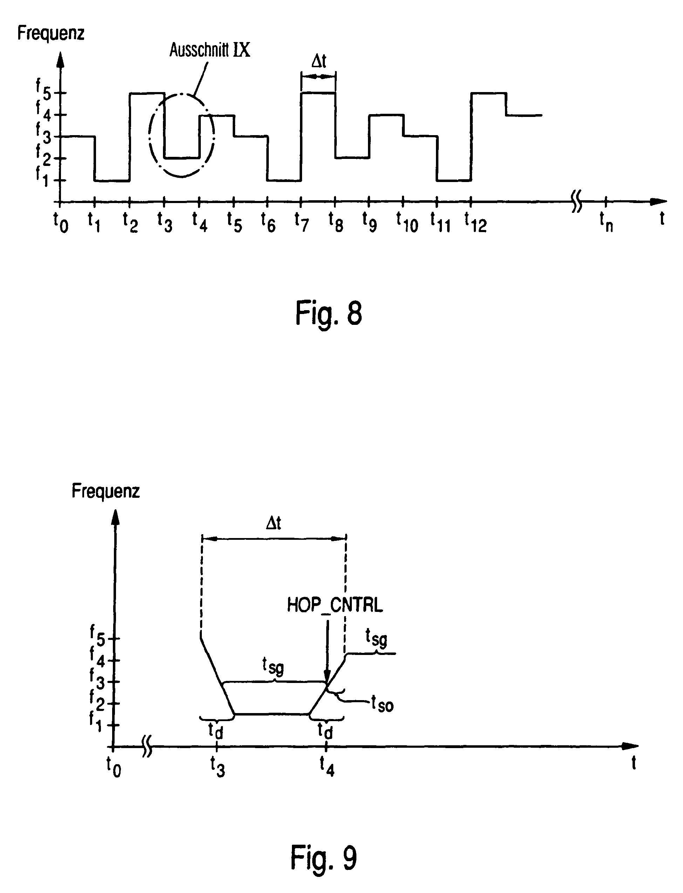

Fig. 8 zeigt ein Schema eines idealisierten zeitlichen Verlaufs eines Frequenzsprungverfahrens mit fünf vor- gesehenen Frequenzen $f_1$, $f_2$, $f_3$, $f_4$, $f_5$. Die zeitliche, sich im vereinfachten Ausführungsbeispiel nach fünf definierten Zeitintervallen $\Delta$t wiederholende Sequenz der vorgesehenen Frequenzen lautet: $f_3$, $f_1$, $f_5$, $f_2$, $f_4$. Bei jedem Wechsel der Frequenz treten im niederfrequenten Audio-Nutzsignal Störimpulse bzw. Störamplituden auf, die eine erheblich höhere Amplitude aufweisen als das Nutzsignal, und als Klick- oder Knack-Geräusch zu hören sind. Die Erfindung dient dazu, diese Geräusche zu unterdrücken.

Fig. 9 zeigt einen zeitlichen Verlauf eines Frequenzsprungs von der Frequenz $f_1$ auf die Frequenz $f_4$ mit einer endlichen Umschaltdauer $t_d$. Innerhalb der Umschaltdauer $t_d$ bewirkt das Steuersignal 11 (HOP_CNTRL) eine offene Schaltstellung der beiden Schaltelemente 25, 26, wobei die Schaltelemente 25, 26 während eines Zeitintervalls $t_{so}$ offen bleiben. Sobald die neue Frequenz aktiv ist, werden beide Schaltelemente 25, 26 wieder geschlossen und verbleiben in der geschlossenen Schaltstellung während der Zeitdauer $t_{sg}$, solange die momentane Frequenz stationär ist. Das Zeitintervall $t_{sg}$ mit geschlossener Schaltstellung ist kleiner als das Zeitintervall $\Delta$t, das einer stationären Phase einer Frequenz bei einem idealen Verlauf des Frequenzsprungverfahrens entspricht.

Die erfindungsgemäße Vorrichtung 1 ist vorzugsweise entweder in einem Empfänger für Audiosignale im Basisband vorgesehen oder in einem Demodulator integriert.

Die Erfindung ist nicht auf die dargestellten Ausführungsbeispiele beschränkt und kann sowohl in einem digitalen Signalprozessor als auch in Hardware implementiert werden. Außerdem kann die Erfindung nicht nur bei Frequenzsprungverfahren angewendet werden, sondern zur Unterdrückung beliebiger Störimpulse nicht nur bei Audiosignalen dienen.

**Patentansprüche**

1.  Vorrichtung (1) zum Begrenzen von Störamplituden (2) in Signalverläufen (3), die dem Eingang der Vorrichtung (1) zugeführt werden, auf dynamisch ermittelte, relativ zu einem mittleren Signalverlauf (4) einstellbare Schwellenwerte (5) mit mindestens einem ersten Eingang (6) und einem Ausgang (23),
    wobei die Vorrichtung (1) Mittelwertbildungsblöcke (15, 16) zum Bilden von zwei Mittelwerten ($\overline{S}_{POS}$, $\overline{S}_{NEG}$) eines Signalverlaufs (3) über einen Zeitraum, einen Betragsbildungsblock (17) zur Bildung eines Absolutbetrags $|\overline{S}_{neg}|$ des negativen Mittelwertes ($\overline{S}_{neg}$), einen Entscheidungsbildungsblock (18) zur Auswahl des kleineren der beiden Mittelwerte ($\overline{S}_{pas.}$, $|\overline{S}_{neg}|$), einen Offset-Block (10) zum Erzeugen eines Schwellenwertes aus dem ausgewählten mit einem Offset skalierten Mittelwerts ($\overline{S}_{POS}$, $|\overline{S}_{NEG}|$), einen Speicher. (19) zum Abspeichern des Schwellenwertes (5), sowie ein Begrenzungselement (21) umfasst, welches entweder in der Vorrichtung (1) ermittelte Schwellenwerte (5) oder am Eingang anliegende Signalverläufe (3) ausgibt, und
    wobei ein Steuersignal (11), welches zeitlich an ein Frequenzsprungverfahren gekoppelt ist, zur Aktivierung der Vorrichtung (1) in regelmäßigen, mit den Frequenzsprüngen synchronen zeitlichen Abständen ($\Delta$t) sowie zur ak- tualisierten Berechnung des Schwellenwertes (5) aus den gebildeten Mittelwerten ($\overline{S}_{POS}$, $|\overline{S}_{NEG}|$) und dem Offset vorgesehen ist.

**2.** Vorrichtung nach Anspruch 1,
**dadurch gekennzeichnet,**
**dass** die aktualisierte Berechnung des Schwellenwerts (5) in definierten zeitlichen Abständen (Δt) vorgesehen ist, die den zeitlichen Abständen (Δt) des Frequenzsprungs entsprechen.

**3.** Vorrichtung nach einem der Ansprüche 1 oder 2,
**dadurch gekennzeichnet,**
**dass** der Offset (10) ein bestimmter, zeitlich konstanter Wert ist.

**4.** Vorrichtung nach einem der Ansprüche 1 bis 3,
**dadurch gekennzeichnet,**
**dass** das Steuersignal (11) über zumindest einen zweiten Eingang (7) der Vorrichtung (1) zuführbar ist oder intern in der Vorrichtung (1) erzeugt wird.

**5.** Vorrichtung nach einem der Ansprüche 1 bis 4,
**dadurch gekennzeichnet,**
**dass** ein erstes Schaltelement (25), ein Verzweigungsblock (12) mit zwei ausgangsseitigen Signalpfaden (13, 14), zwei Mittelwertbildungsblöcke (15, 16), ein Betragsbildungsblock (17), ein Entscheidungsblock (18), ein Speicher (19), ein Addierer (20), ein zweites Schaltelement (26) und ein Begrenzungselement (21) vorgesehen sind.

**6.** Vorrichtung nach Anspruch 5,
**dadurch gekennzeichnet,**
**dass** bei einer geschlossenen Schaltstellung der Schaltelemente (25, 26) das Signal in dem Verzweigungsblock (12) in Abhängigkeit von seinem Vorzeichen in den ersten Signalpfad (13) und in den zweiten Signalpfad (14) aufgeteilt wird, wobei im ersten Signalpfad (13) positive Signalwerte in dem ersten Mittelwertbildungsblock (15) zu ersten positiven Mittelwerten ($\overline{S}_{POS}$) verarbeitet werden und im zweiten Signalpfad (14) negative Signalwerte in dem zweiten Mittelwertbildungsblock (16) zu negativen Mittelwerten ($\overline{S}_{NEG}$) verarbeitet werden, die in einem anschließenden Betragsbildungsblock (17) zu zweiten positiven Mittelwerten verarbeitet werden.

**7.** Vorrichtung nach Anspruch 6,
**dadurch gekennzeichnet,**
**dass** in dem Entscheidungsblock (18) der kleinere Wert des ersten oder zweiten positiven Mittelwerts der beiden Signalpfade (13, 14) ausgewählt wird und als kleinerer positiver Mittelwert verarbeitet wird.

**8.** Vorrichtung nach Anspruch 7,
**dadurch gekennzeichnet,**
**dass** in dem Addierer (20) der Schwellenwert (5) gemäß folgender Formel gebildet wird:

$$\text{Schwellenwert} = \text{kleinerer positiver Mittelwert} \cdot (1 + \text{Offset})$$
$$\text{mit Offset} > 0.$$

Schwellenwert = kleinerer positiver Mittelwert (1+Offset) mit Offset > 0.

**9.** Vorrichtung nach einem der Ansprüche 5 bis 8,
**dadurch gekennzeichnet,**
**dass** bei einer geschlossenen Schaltstellung des zweiten Schaltelements (26) in dem Speicher (19) ein aktualisierter Schwellenwert (5) abgespeichert wird.

**10.** Vorrichtung nach einem der Ansprüche 5 bis 9,
**dadurch gekennzeichnet,**
**dass** das vor dem Ausgang (23), der Vorrichtung (1) angeordnete Begrenzungselement (21) den aktuellen, am ersten Eingang (6) anliegenden Signalwert mit dem ermittelten Schwellenwert (5) vergleicht und den kleineren der beiden Werte an dem Ausgang (23) der Vorrichtung (1) ausgibt.

**11.** Vorrichtung nach einem der Ansprüche 1 bis 10,
**dadurch gekennzeichnet,**

**dass** die Vorrichtung (1) in einem Funkempfänger im Basisbandteil vorgesehen ist oder in einem Demodulator integriert ist.

**12.** Verfahren zum Begrenzen von Störamplituden (2) in Signalverläufen (3) auf dynamisch ermittelte, relativ zu einem mittleren Signalverlauf (4) einstellbare Schwellenwerte (5), wobei das Verfahren folgende Verfahrensschritte umfasst:

- mittels eines Steuersignals (11) wird das Verfahren, welches zeitlich an ein einen Frequenzsprung bei einem Frequenzsprungverfahren, gekoppelt ist, aktiviert,
- ein am Eingang anliegender Signalverlauf (3) wird auf zwei Signalpfade aufgeteilt, wobei ein erster Signalpfad (13) positive Signalamplituden und ein zweiter Signalpfad (14) negative Signalamplituden enthält,
- die Schwellenwerte (5) werden dynamisch aus dem Signalverlauf (3) gebildet, indem innerhalb eines definierten Zeitraums jeweils ein Mittelwert der Signalanteile in den beiden Signalpfaden (13, 14) berechnet wird und der aus negativen Signalamplituden gebildete Mittelwert einer Absolutbetrag-Bildung unterworfen wird, wobei der kleinere der beiden Werte weiterverarbeitet wird,
- aus der Summe des kleineren Wertes und des mit einem Offset (10) multiplizierten Wertes wird der aktuelle Schwellenwert (5) ermittelt und gespeichert,
- es wird der aktuell ermittelte Schwellenwert (5) mit dem aktuell vorliegenden Signalverlauf (3) verglichen und der kleinere Wert ausgegeben.

**13.** Verfahren nach Anspruch 12,
**dadurch gekennzeichnet,**
**dass** der aktuelle Schwellenwert (5) in definierten zeitlichen Abständen ($\Delta t$) ermittelt wird, die mit den zeitlichen Abständen ($\Delta t$) des mit dem Steuersignal (11) gekoppelten Frequenzsprungs übereinstimmen.

**14.** Verfahren nach Anspruch 12,
**dadurch gekennzeichnet,**
**dass** das Signal (3) in Abhängigkeit seines Vorzeichens in einen ersten Signalpfad (13) und in einen zweiten Signalpfad (14) aufgeteilt wird, wobei im ersten Signalpfad (13) positive Signalwerte zu ersten positiven Mittelwerten ($\overline{S}_{POS}$) verarbeitet werden und im zweiten Signalpfad (14) negative Signalwerte zu negativen Mittelwerten ($\overline{S}_{NEG}$) verarbeitet werden, um bei einer anschließenden Betragsbildung (17) zu zweiten positiven Mittelwerten verarbeitet zu werden.

**15.** Verfahren nach Anspruch 14,
**dadurch gekennzeichnet,**
**dass** nur der kleinere positive Mittelwert der beiden Signalpfade (13, 14) weiterverarbeitet wird.

**16.** Verfahren nach Anspruch 15,
**dadurch gekennzeichnet,**
**dass** der Schwellenwert (5) aus folgender Formel berechnet wird:

```
Schwellenwert = kleinerer positiver Mittelwert•(1+Offset)
mit Offset > 0.
```

**Claims**

**1.** Apparatus (1) for limiting spurious amplitudes (2) in signal profiles (3), supplied to the input of the apparatus (1), to dynamically ascertained threshold values (5) which can be adjusted relative to an average signal profile (4), having at least one first input (6) and an output (23), wherein the apparatus (1) comprises averaging blocks (15, 16) for forming two averages ($\overline{S}_{POS}$, $\overline{S}N_{EG}$) for a signal profile (3) over a period of time, an absolute-value formation block (17) for forming an absolute value $|\overline{S}_{NEG}|$ for the negative average ($\overline{S}_{NEG}$), a decision-making block (18) for selecting the smaller of the two averages ($\overline{S}_{POS}$, $|\overline{S}_{NEG}|$), an offset block (10) for producing a threshold value from the selected average scaled with an offset ($\overline{S}_{POS}$, $|\overline{S}_{NEG}|$), a memory (19) for storing the threshold value (5) and a limiting element (21), which outputs either threshold values (5) ascertained in the apparatus (1) or signal profiles (3) applied to the input, and

wherein a control signal (11), the timing of which is coupled to a frequency hopping method, is provided for the purpose of activating the apparatus (1) at regular intervals of time ($\Delta$t) which are in sync with the frequency hops and also for the purpose of updated calculation of the threshold value (5) from the averages formed ($\overline{S}_{POS}$, $|\overline{S}_{NEG}|$) and the offset.

2. Apparatus according to Claim 1,
   **characterized**
   **in that** the updated calculation of the threshold value (5) is provided at defined intervals of time ($\Delta$t) which correspond to the intervals of time ($\Delta$t) from the frequency hop.

3. Apparatus according to one of Claims 1 and 2,
   **characterized**
   **in that** the offset (10) is a particular value which is constant over time.

4. Apparatus according to one of Claims 1 to 3,
   **characterized**
   **in that** the control signal (11) can be supplied to the apparatus (1) via at least one second input (7) or is produced internally in the apparatus (1).

5. Apparatus according to one of Claims 1 to 4,
   **characterized**
   **in that** a first switching element (25), a branching block (12) having two output-side signal paths (13, 14), two averaging blocks (15, 16), an absolute-value formation block (17), a decision block (18), a memory (19), an adder (20), a second switching element (26) and a limiting element (21) are provided.

6. Apparatus according to Claim 5,
   **characterized**
   **in that** when the switching elements (25, 26) are in a closed switching position, the signal in the branching block (12) is split into the first signal path (13) and into the second signal path (14) on the basis of its arithmetic sign, wherein the first signal path (13) processes positive signal values in the first averaging block (15) to form first positive averages ($\overline{S}_{POS}$) and the second signal path (14) processes negative signal values in the second averaging block (16) to form negative averages ($\overline{S}_{NEG}$), which are processed in a subsequent absolute-value formation block (17) to form second positive averages.

7. Apparatus according to Claim 6,
   **characterized**
   **in that** the decision block (18) selects the smaller value of the first or second positive average from the two signal paths (13, 14) and processes it as a smaller positive average.

8. Apparatus according to Claim 7,
   **characterized**
   **in that** the adder (20) forms the threshold value (5) on the basis of the following formula:

   ```
   threshold value = smaller positive average • (1+offset)
   with offset › 0.
   ```

9. Apparatus according to one of Claims 5 to 8,
   **characterized**
   **in that** when the second switching element (26) is in a closed switching position, the memory (19) is used to store an updated threshold value (5).

10. Apparatus according to one of Claims 5 to 9,
    **characterized**
    **in that** the limiting element (21) arranged upstream of the output (23) of the apparatus (1) compares the current signal value applied to the first input (6) with the ascertained threshold value (5) and outputs the smaller of the two values at the output (23) of the apparatus (1).

**11.** Apparatus according to one of Claims 1 to 10,
**characterized**
**in that** the apparatus (1) is provided in a radio receiver in the baseband part or is integrated in a demodulator.

**12.** Method for limiting spurious amplitudes (2) in signal profiles (3) to dynamically ascertained threshold values (5) which can be adjusted relative to an average signal profile (4),
wherein the method comprises the following method steps:

- a control signal (11) is used to activate the method, the timing of which is coupled to a frequency hop in a frequency hopping method,
- a signal profile (3) applied to the input is split over two signal paths, wherein a first signal path (13) contains positive signal amplitudes and a second signal path (14) contains negative signal amplitudes,
- the threshold values (5) are formed dynamically from the signal profile (3) by calculating a respective average for the signal components in the two signal paths (13, 14) within a defined period of time and subjecting the average formed from negative signal amplitudes to absolute-value formation, wherein the smaller of the two values is processed further,
- the current threshold value (5) is ascertained from the sum of the smaller value and the value multiplied by an offset (10) and is stored,
- the currently ascertained threshold value (5) is compared with the currently available signal profile (3), and the smaller value is output.

**13.** Method according to Claim 12,
**characterized**
**in that** the current threshold value (5) is ascertained at defined intervals of time ($\Delta$t) which match the intervals of time ($\Delta$t) from the frequency hop coupled to the control signal (11).

**14.** Method according to Claim 12,
**characterized**
**in that** the signal (3) is split into a first signal path (13) and into a second signal path (14) on the basis of its arithmetic sign, wherein the first signal path (13) processes positive signal values to form first positive averages ($\overline{S}_{POS}$) and the second signal path (14) processes negative signal values to form negative averages ($\overline{S}_{NEG}$) so as to be processed to form second positive averages during subsequent absolute-value formation (17).

**15.** Method according to Claim 14,
**characterized**
**in that** only the smaller positive average from the two signal paths (13, 14) is processed further.

**16.** Method according to Claim 15,
**characterized**
**in that** the threshold value (5) is calculated from the following formula:

```
threshold value = smaller positive average • (1+offset)
with offset > 0.
```

**Revendications**

**1.** Dispositif (1) de limitation d'amplitudes parasites (2) dans des formes d'ondes de signaux (3), qui sont délivrées à l'entrée du dispositif (1), à des valeurs de seuil (5) détectées de façon dynamique et pouvant être réglées par rapport à une forme d'onde de signal moyenne (4) qui comporte une première entrée (6) et une sortie (23),
dans lequel le dispositif (1) comprend des blocs de formation de valeur moyenne (15, 16) pour former deux valeurs moyennes ($\overline{S}_{POS}$, $\overline{S}_{NEG}$) d'une forme d'onde de signal (3) sur un intervalle de temps, un bloc de formation de valeurs absolues (17) pour la formation d'une valeur absolue ($|\overline{S}_{NEG}|$) de la valeur moyenne négative ($\overline{S}_{NEG}$), un bloc de formation de décision (18) pour la sélection de la plus petite des deux valeurs moyennes ($\overline{S}_{POS}$, $|\overline{S}_{NEG}|$), un bloc de décalage (10) pour générer une valeur de seuil à partir de la valeur moyenne ($\overline{S}_{POS}$, $|\overline{S}_{NEG}|$) sélectionnée échelonnée avec un décalage, une mémoire (19) pour mémoriser la valeur de seuil (5), ainsi qu'un élément de limitation (21), qui délivre soit des valeurs de seuil (5) détectées dans le dispositif (1) soit des formes d'onde de signaux (3) se trouvant à l'entrée, et

dans lequel est prévu un signal de commande (11), qui est couplé temporellement à un procédé de sauts de fréquence, pour activer le dispositif (1) à des distances ($\Delta$t) régulières temporelles synchrones avec les sauts de fréquence ainsi que pour un calcul actualisé de la valeur de seuil (5) à partir des valeurs moyennes formées ($\overline{S}_{POS}$, $|\overline{S}_{NEG}|$) et du décalage.

2. Dispositif selon la revendication 1, **caractérisé en ce que**
le calcul actualisé de la valeur de seuil (5) est prévu à des distances temporelles définies ($\Delta$t), qui correspondent aux distances temporelles ($\Delta$t) du saut de fréquence.

3. Dispositif selon l'une des revendications 1 ou 2, **caractérisé en ce que**
le décalage (10) est une valeur déterminée temporellement constante.

4. Dispositif selon l'une des revendications 1 à 3, **caractérisé en ce que**
le signal de commande (11) peut être délivré par l'intermédiaire d'au moins une seconde entrée (7) du dispositif (1) ou est généré à l'intérieur du dispositif (1).

5. Dispositif selon l'une des revendications 1 à 4, **caractérisé en ce que**
sont prévus un premier élément de commutation (25), un bloc de test logique (12) comportant deux trajets de signaux (13, 14) côté sortie, deux blocs de formation de valeurs moyennes (15, 16), un bloc de formation de quantité (17), un bloc de décision (18), une mémoire (19), un additionneur (20), un second élément de commutation (26) et un élément de limitation (21).

6. Dispositif selon la revendication 5, **caractérisé en ce que**
dans le cas d'une position de commutation fermée des éléments de commutation (25, 26), le signal dans le bloc de test logique (12) est divisé selon son signe en un premier trajet de signal (13) ou dans un second trajet de signal (14), dans lequel, dans le premier trajet du signal (13), des valeurs de signal positives sont transformées dans le premier bloc de formation de valeur moyenne (15) en premières valeurs moyennes positives ($\overline{S}_{POS}$) et dans le second trajet de signal (14), des valeurs de signal négatives sont transformées dans le second bloc de formation de valeur moyenne (16) en valeurs moyennes négatives ($\overline{S}_{NEC}$), qui sont transformées en secondes valeurs moyennes positives dans un bloc de formation de quantité terminal (17).

7. Dispositif selon la revendication 6, **caractérisé en ce que**
dans le bloc de décision (18), la plus petite valeur des premières ou secondes valeurs moyennes positives des trajets de signaux (13, 14) est sélectionnée et est transformée en plus petite valeur moyenne positive.

8. Dispositif selon la revendication 7, **caractérisé en ce que**
dans l'additionneur (20), la valeur de seuil (5) est formée selon la formule suivante:

```
valeur de seuil = plus petite valeur moyenne positive · (1+
décalage) avec décalage > 0.
```

9. Dispositif selon l'une des revendications 5 à 8, **caractérisé en ce que**
dans le cas d'une position de commutation fermée du second élément de commutation (26), une valeur de seuil actualisée (5) est mémorisée dans la mémoire (19).

10. Dispositif selon l'une des revendications 5 à 9, **caractérisé en ce que**,
l'élément de limitation (21) disposé avant la sortie (23) du dispositif (1) compare la valeur de signal actuelle se trouvant à la première entrée (6) à une valeur de seuil détectée (5) et délivre la plus petite des deux valeurs à la sortie (23) du dispositif (1).

11. Dispositif selon l'une des revendications 1 à 10, **caractérisé en ce que**
le dispositif (1) est prévu dans un récepteur radio dans la partie bande de base ou est intégré dans un démodulateur.

12. Procédé de limitation des amplitudes parasites (2) dans des formes d'onde de signaux (3) à des valeurs de seuil

EP 1 753 131 B1

(5) détectées de façon dynamique, pouvant être réglées par rapport à une forme d'onde de signal moyenne (4), dans lequel le procédé comporte les étapes de procédé suivantes:

- grâce à un signal de commande (11), le procédé, qui est couplé temporellement à un saut de fréquence dans un procédé de sauts de fréquence, est activé ;
- une forme d'onde de signal (3) se trouvant à l'entrée est divisée en deux trajets de signaux, dans lequel un premier trajet de signal (13) contient des amplitudes de signal positives et un second trajet de signal (14) contient des amplitudes de signal négatives,
- les valeurs de seuil (5) sont formées de façon dynamique à partir de la forme d'onde de signal (3), où, à l'intérieur d'un intervalle temporel défini, une valeur moyenne respective des parties de signal est calculée dans les deux trajets de signaux (13, 14) et la valeur moyenne formée à partir des amplitudes de signal négatives est soumise à une formation de valeur absolue, où la plus petite des deux valeurs est de nouveau transformée,
- à partir de la somme de la plus petite valeur et de la valeur multipliée par un décalage (10), la valeur de seuil actuelle (5) est déterminée et mémorisée,
- la valeur de seuil actuellement déterminée (5) est comparée à la forme d'onde de signal actuellement présente (3) et la plus petite valeur est délivrée.

13. Procédé selon la revendication 12, **caractérisé en ce que**
la valeur de seuil actuelle (5) est déterminée à des distances temporelles définies ($\Delta$t), qui correspondent aux distances temporelles ($\Delta$t) du saut de fréquence couplées au signal de commande (11).

14. Procédé selon la revendication 12, **caractérisé en ce que**
le signal (3) est divisé selon son signe en un premier trajet de signal (13) et en un second trajet de signal (14), dans lequel, dans le premier trajet de signal (13), des valeurs de signal positives sont transformées en premières valeurs moyennes positives ($\overline{S}_{POS}$) et dans le second trajet de signal (14), des valeurs de signal négatives sont transformées en valeurs moyennes négatives ($\overline{S}_{NEG}$), pour être transformées en secondes valeurs moyennes positives dans le cas d'une formation de quantité terminale (17).

15. Procédé selon la revendication 14, **caractérisé en ce que**
seule la plus petite valeur moyenne positive des deux trajets de signaux (13, 14) est de nouveau transformée.

16. Procédé selon la revendication 15, **caractérisé en ce que**
la valeur de seuil (5) est calculée à partir de la formule suivante:

```
valeur de seuil = plus petite valeur moyenne positive o (1 +
décalage) avec décalage > 0.
```

10

# Fig. 1

Fig. 2

Fig. 3

Fig. 4

Fig. 5

Fig. 6

Fig. 7

Fig. 8

Fig. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0419186 B1

- US 3277384 A